**Europäisches Patentamt**

**European Patent Office**

**Office européen des brevets**

(19)

(11) Publication number: **0 080 042**
**B1**

(12) **EUROPEAN PATENT SPECIFICATION**

(45) Date of publication of patent specification: **20.01.88**

(51) Int. Cl.⁴: **G 03 F 7/26**

(21) Application number: **82108786.3**

(22) Date of filing: **22.09.82**

(54) **Method for the development of photoresist layers, and developer.**

(30) Priority: **28.09.81 JP 153292/81**

(43) Date of publication of application:
**01.06.83 Bulletin 83/22**

(45) Publication of the grant of the patent:
**20.01.88 Bulletin 88/03**

(84) Designated Contracting States:
**DE FR GB**

(56) References cited:
**EP-A-0 049 769**
**DE-A-3 008 824**
**US-A-3 201 241**
**US-A-3 615 480**
**US-A-4 291 117**

(73) Proprietor: **FUJI PHOTO FILM CO., LTD.**
**210 Nakanuma Minami Ashigara-shi**
**Kanagawa 250-01 (JP)**

(72) Inventor: **Kita, Nobuyuki**
**c/o Fuji Photo Film Co., Ltd. No. 4000, Kawajiri**
**Yoshida-cho Haibara-gun Shizuoka (JP)**
Inventor: **Miyano, Shizuo**
**c/o Fuji Photo Film Co., Ltd. No. 4000, Kawajiri**
**Yoshida-cho Haibara-gun Shizuoka (JP)**
Inventor: **Tetsuo, Hara**
**c/o Fuji Photo Film Co., Ltd. No. 13-6, Minami**
**Azabu 2-chome Minato-ku Tokyo (JP)**

(74) Representative: **Patentanwälte Grünecker, Dr.**
**Kinkeldey, Dr. Stockmair, Dr. Schumann, Jakob,**
**Dr. Bezold, Meister, Hilgers, Dr. Meyer-Plath**
**Maximilianstrasse 58**
**D-8000 München 22 (DE)**

## 0 080 042

**Description**

The present invention relates to a developer for removing the unexposed area of a photosensitive material having a light-hardenable photosensitive layer containing, as one component, an organic high-molecular weight polymer with an acid value of from 10 to 200, to a method of development and to the use of the developer.

US—A—3 615 480 discloses an aqueous developer solution for removing the unexposed area of a light-hardenable photosensitive layer containing at least one non-gaseous addition polymerizable monomer having at least two terminal ethylenic groups and an organic macromolecular polymer binder for the monomer essentially comprising a soluble lithium, sodium or potassium metal silicate having a certain silica to alkali metal oxide ratio, at least one water-miscible organic solvent selected from low-molecular-weight aliphatic alcohols, ketones and ethers, and, optionally, a surfactant and a water-softening agent having a sequestering effect for calcium ions and/or magnesium ions.

JP—A—77401/76 discloses a composition comprising an anionic surfactant, benzyl alcohol, an alkali agent and water, and this composition is used as a developer for removing the unexposed area of a photosensitive layer comprising an organic high-molecular weight polymer having an acid value of 10 to 100 and a photosensitive diazo compound. The developer is usually supplied as a concentrated solution to the user who dilutes it with water to a desired concentration on use. However, in some cases, the development achieved is insufficient (i.e., the photosensitive layer is not completely removed from the unexposed area) and slimy insoluble matter is formed in large quantities in the developer. The problems prevent the developer from performing its function to the fullest extent.

The problem underlying the present invention is to provide a developer for removing the unexposed area of a light-hardenable photosensitive layer including an organic high-molecular weight polymer with an acid value of 10 to 200 and an organic solvent soluble diazo resin, namely, a sulfonate or a hexafluorophosphate of condensation products of p-diazodiphenyl amines and formaldehyde or acetaldehyde, said developer being capable of avoiding insufficient development and the formation of slimy insoluble matter.

According to the present invention, this problem is solved by a developer as indicated in claim 1, which is characterized in that it further comprises from 0.01 to 5 weight percent of a water-softening agent having a sequestering ratio for calcium ions and/or magnesium ions of at least 50% at the pH of said developer.

As a result of various studies to eliminate the above-mentioned problems of the prior art, it has unexpectedly been found that these problems are due to the high hardness of the water used to dilute the concentrated bulk developer. It has also been found that insufficient development takes place in all cases where light-hardenable photosensitive layers containing organic high-molecular polymers with an acid value of 10 to 200 are developed.

The present developer can be diluted with water with a high degree of hardness without insufficient development ocurring and without large quantities of slimy insoluble matter being formed.

The probable reason why insufficient development and slimy insoluble matter in the developer according to the invention can be avoided by incorporating a water softening agent is as follows. An organic high-molecular weight polymer having an acid value of 10 to 200 in the unexposed area of the photosensitive layer reacts with the alkali agent in the developer to become water-soluble and dissolves out in the developer. If hard water has been used to dilute the concentrated developer, the organic high-molecular weight polymer is ionically crosslinked due to calcium ions and/or magnesium ions present in the hard water. Since the ionically crosslinked polymer is only sparingly soluble or completely insoluble in the developer, insufficient development occurs and the insoluble polymer builds up in the developer as slimy insolubles, which further increases the insufficiency of development. However, the water softening agent in the developer sequesters the calcium ions and/or magnesium ions in the developer. Therefore, there is no chance for the organic high-molecular weight polymer having an acid value of 10 to 200 to be crosslinked ionically. As a result, complete development is achieved and no slimy insoluble matter is formed in the developer.

Since the developer is an alkaline material, the water softening agent used in the developer of the present invention must be capable of sequestering calcium ions and magnesium ions under alkaline conditions. It must have a sequestering ratio of least 50% (equivalent to the water softening agent having a chelate stability constant (log K) to calcium ion of about 4 or more) at the pH of the developer. A water-softening agent having a sequestering ratio of 50% at a pH of 9 is preferred. Typical examples of suitable water softening agents include polyphosphate salts such as $Na_4P_2O_7$, $Na_5P_3O_{10}$, $Na_3P_3O_9$, $Na_4P_4O_{12}$, Calgon (sodium polymetaphosphate produced by Hoechst AG); and aminopolycarboxylic acids such as ethylenediaminetetraacetic acid, diethylenetriaminepentaacetic acid, triethylenetetramine-hexaacetic acid, hydroxyethylenediaminetriacetic acid, nitrilotriacetic acid, 1,2-diaminocyclohexane-tetraacetic acid and 1,3-diamino-2-propanoltetraacetic acid, as well as the alkali metal salts thereof such as the potassium and sodium salts; and organophosphonic acids or phosphonocarboxylic acids such as aminotri(methylenephosphonic acid), l - hydroxyethylidene - 1,1 - diphosphonic acid, 2-phosphonobutanetricarboxylic acid-1,2,4,2-amino-2-methyl-1-hydroxypropane-1,1-diphosphonic acid or 2-pyridine-1-hydroxymethane-1,1-diphosphonic acid, or the potassium salts or sodium salts thereof. Particularly preferred examples are aminopolycarboxylic acids or the potassium or sodium salts thereof,

2

# 0 080 042

since these sequester calcium ions or magnesium ions quite well with a small amount thereof. Preferably 0.01 to 0.5 wt % of the water softening agent is used.

Illustrative anionic surfactants for use in the developer of the invention include salts of sulfate esters of higher alcohols having 8 to 22 carbon atoms such as the sodium salt of lauryl alcohol sulfate, the sodium salt of octyl alcohol sulfate, the ammonium salt of lauryl alcohol sulfate and secondary sodium alkyl sulfate; salts of aliphatic alcohol phosphate esters such as the sodium salt of cetyl alcohol phosphate ester; salts of alkylaryl sulfonic acids such as the sodium salt of dodecyl benzenesulfonic acid, the sodium salt of isopropyl naphthalenesulfonic acid, the disodium salt of alkyl diphenylether disulfonic acid, $C_8F_{17}SO_3K$, and the sodium salt of metanitrobenzenesulfonic acid; salts of alkylamide sulfonic acids such as $C_{17}H_{33}CON(CH_3)CHCH_2SO_3Na$; and sulfate salts of dibasic aliphatic acid esters such as dioctyl sodium sulfosuccinate and dihexyl sodium sulfosuccinate.

These surfactants are generally present in the diluted developer in an amount of about 0.1 to 5 wt%. If the amount of the surfactant is less than about 0.1 wt%, their intended effect is not fully achieved, and if the amount exceeds about 5 wt%, the dye in the hardened areas of the light-hardenable photosensitive layer dissolves into the developer in an excessive amount or the image in the hardened areas has poor mechanical strength (e.g., low wear resistance) and chemical strength. The preferred range is from 0.5 to 1.5 wt%.

The organic solvents benzyl alcohol and 2-phenoxyethanol are present in the developer preferably in an amount of about 1 to 5 wt% based on the weight of the diluted developer. Their amount is closely related to the amount of the surfactants used, and the amount of the surfactunts is preferably increased as the amount of the organic solvents is increased. This is because, if too much organic solvent is used in comparison with the surfactants, the solvents will not completely dissolve in water and hence, the desired development cannot be achieved.

The alkali agent is selected from at least one of triethanolamine, diethanolamine and monoethanol amine and is generally present in the developer of the invention in an amount of about 0.05 to 3 wt%, preferably from 0.1 to 1 wt%, such that the pH of the diluted developer is about 8 to 11. If the amount of the alkali agent is less than about 0.05 wt%, the unhardened photosensitive layer is not completely removed, and if the amount exceeds about 3 wt%, the light-hardened area of the photosensitive layer has low mechanical and chemical strength, and a lithographic printing plate prepared from such a photosensitive layer has only a short printing life.

The remainder of the developer of the present invention is water, but it may optionally contain various additives conventionally used in the art.

For the sake of convenience in transportation, the developer of the present invention is advantageously supplied to the user in a concentrated bulk form which is diluted with water before use. A suitable degree of concentration is such that the individual components of the developer will not separate from each other or will not form a precipitate. According to the present invention, the concentrated developer need not be diluted with pure water; and water having an American hardness (hereunder abbreviated to AH) of 50 ppm or more may be used without any disadvantage.

The photosensitive material that can be processed with the developer of the present invention has a light-hardenable photosensitive layer containing an organic high-molecular weight polymer with an acid value of 10 to 200 and a photosensitive diazo compound, namely a sulfonate or hexafluorophosphate of condensation products of p-diazodiphenyl amines and formaldehyde or acetaldehyde.

Specific examples of the organic high-molecular weight polymers having an acid value of 10 to 200 are copolymers containing acrylic acid, methacrylic acid, crotonic acid or maleic acid as an essential comonomer, such as terpolymers or tetrapolymers as disclosed in US—A—4,123,276 comprising 2-hydroxyethyl acrylate or 2-hydroxyethyl methacrylate, acrylonitrile or methacrylonitrile, and acrylic acid or methacrylic acid, and an optional comonomer; copolymers as disclosed in JP—A—120903/78 which comprise acrylic acid or methacrylic acid wherein a terminal hydroxyl group is esterified with a group containing a dicarboxylic acid ester residue an acrylic acid or methacrylic acid, and an optional comonomer; copolymers as disclosed in JP—A—98614/79 comprising a monomer having a terminal aromatic hydroxyl group (e.g., N-(4-hydroxyphenyl)methacrylamide), acrylonitrile, methacrylonitrile, and acrylic acid or methacrylic acid, and optionally at least one other comonomer; and copolymers as disclosed in JP—A—4144/81 comprising alkyl acrylate or methacrylate, acrylonitrile or methacrylonitrile and an unsaturated carboxylic acid. Other useful polymers are acid polyvinyl alcohol derivatives and acidic cellulose derivatives. Particularly preferred organic high molecular weight polymers are multi-component copolymers comprising hydroxy group-containing (meth)acrylates, acrylonitriles, (meth)acrylic acids, or (meth)acrylates, as disclosed in, for example, US—A—4,123,276 and JP—A—98614/79.

Optional comonomers which can be present are monomers which are copolymerizable with (meth)acrylonitrile and (meth) acrylic acid, and include (meth) acrylate, stryene, vinyl toluene, crotonic acid ester, (meth)acrylamide, N-acetyl(meth)acrylamide and N-aryl(meth)acrylamide.

Specific examples of the sulfonates of condensation products of p-diazodiphenylamine and formaldehyde are p-toluenesulfonate and 2-methoxy-4-hydroxy-5-benzoylbenzene-sulfonate. Condensation products of p-diazodiphenylamine in which a methoxy, ethoxy, methyl or ethyl group has been introduced into the phenyl nucleus can also be used. The photosensitive diazo compounds are

3

**0 080 042**

present in light-hardenable photosensitive layer in an amount of from about 5 to 50 wt%, preferably from 8 to 20 wt%.

The light-hardenable photosensitive layer described above is formed on a support which can be selected from various types of supports according to the object. To prepare a presensitized lithographic printing plate, a metal support such as an aluminum plate is preferred. The surface of the aluminum plate is preferably subjected to a surface treatment, such as a treatment with an aqueous solution of an alkali metal silicate salt as described in US—A—2,714,066 or an anodization followed by treatment with an aqueous solution of an alkali metal silicate salt as disclosed in US—A—3,181,461. The so-treated aluminum plate is coated with the photosensitive layer in a thickness of about 0.1 to 7 g/m², preferably from 0.2 to 5 g/m², to thereby prepare a presensitized lithographic printing plate precursor. The printing plate precursor is subjected to imagewise exposure through a transparency to a light source rich in ultraviolet rays, such as a metal halide lamp. Then, the plate is processed with the developer of the present invention to produce a lithographic printing plate with the photosensitive layer removed from the unexposed area. As described above, the developer of the present invention can be used with a presensitized lithographic printing plate but it can also be applied to a photomask making sensitive material or a photoresist with equal advantage.

The present invention is now described in greater detail by reference to the following examples. Unless otherwise, noted, all percents in the examples are by weight.

Example 1

Ethylene glycol monomethyl ether (300 g) was heated at 100°C in a nitrogen stream, and a liquid mixture of 2-hydroxyethyl methacrylate (70 g), acrylonitrile (80 g), benzyl methacrylate (130 g), methacrylic acid (20 g) and benzoyl peroxide (1.2 g) was added dropwise over 2 hours. Fifteen minutes after the completion of the addition, a mixture of ethylene glycol monomethyl ether (300 g) and benzoyl peroxide (0.3 g) was added, and the reaction was continued for 4 hours. After completion of the reaction, the reaction mixture was diluted with methanol and poured into water to precipitate a copolymer which was vacuum-dried at 70°C. The resulting 2-hydroxyethyl methacrylate copolymer (I) had an acid value of 40.2.

A 2S aluminum plate 0.15 mm thick was degreased by immersing it in a 10% aqueous solution of sodium tertiary phosphate (80°C) for 3 minutes, grained with a nylon brush and desmutted with a 3% aqueous solution of sodium aluminate at 60°C. The aluminum plate was anodized in a 20% sulfuric acid aqueous solution for 2 minutes at a current density of 2 A/dm², then treated with a 2.5% aqueous solution of sodium silicate at 70°C for one minute.

The so-treated aluminum plate was coated with a photosensitive solution of the following formulation and dried at 100°C for 2 minutes to prepare a presensitized lithographic printing place precursor.

| | |
|---|---|
| 2-Hydroxymethyl methacrylate copolymer (I) | 87 g |
| 2-Methoxy-4-hydroxy-5-benzoylbenzenesulfonic acid salt of p-diazodiphenyl-amine-paraformaldehyde condensate | 10 g |
| Oil blue # 603 (oil soluble, triphenylmethane dye from Orient Chemical Industry Co., Ltd.) | 3 g |
| 2-Methoxyethanol | 600 g |
| Methanol | 600 g |
| Ethylene dichloride | 600 g |

The dry weight of the coating was 2.5 g/m². The presensitized printing plate precursor was subjected to image-wise exposure for 40 seconds at a distance of 70 cm to a 30-A carbon arc lamp through a negative transparency placed in intimate contact with the plate. The plate was then processed in a commercial automatic developing machine at 25°C for 50 seconds with a developer prepared by diluting a concentrated developer of the following formulation with water having an AH of 270 ppm in a developer-to-water volume ratio of 1:1.

| | |
|---|---|
| Benzyl alcohol | 90 g |
| Triethanolamine | 30 g |
| Sodium isopropylnaphthalenesulfonate | 30 g |
| Sodium sulfite | 6 g |
| Trisodium nitrilotriacetate | 0.5 g |
| Ion-exchanged water | 844 g |

4

The resulting lithographic printing plate precursor had no film of unhardened photosensitive layer left on the nonimage area due to incomplete development. The plate was set in an offset printing machine and the desired image could be printed on at least 80,000 sheets of quality paper.

A control concentrated developer that was the same as described above except that it did not contain any trisodium nitrilotriacetate as a water softening agent was diluted with water (AH=270 ppm) in a volume ratio of 1:1. When a presensitized printing plate precuror as described above was processed with this control developer, a printing plate having a film of unhardened photosensitive layer remaining on the nonimage area was produced. On printing with this plate on a printing machine, the ink smeared the nonimage area. When many presensitized lithographic printing plates that had been subjected to imagewise exposure were processed with the same automatic developing machine, slime deposited on the bottom of the developer tank. No such deposit was formed when the plate was processed with the developer of the present invention although it was prepared by diluting a concentrated developer with hard water.

Examples 2 to 6

Lithographic printing plate precursors were made as in Example 1 except that developers were prepared by diluting the concentrate developers indicated in the following table with samples of water. The values of AH of the water samples and the developer-to-water ratios are also indicated in the table. The plates produced had no stain on the nonimage area.

| Example No. | Formulation of concentrated developer | | Hardness of diluting water | Developer to water ratio | Result of development |
|---|---|---|---|---|---|
| | Benzyl alcohol | 90 g | | | |
| | Sodium isopropyl naphthalenesulfonate | 30 g | | | |
| | Triethanolamine | 30 g | | | |
| | Monoethanolamine | 2 g | | | |
| 2 | Sodium phosphite | 6 g | 400 ppm | 1:1 | good |
| | Tetrasodium ethylene-diamine tetraacetate | 0.5 g | | | |
| | Ion exchanged water | 842 g | | | |
| 3 | Same as above | | 400 ppm | 1:0.5 | good |
| | Benzyl alcohol | 90 g | | | |
| | Sodium isopropyl naphthalenesulfonate | 30 g | | | |
| | Triethanolamine | 30 g | | | |
| 4 | Monoethanolamine | 2 g | 270 ppm | 1:1 | good |
| | Sodium phosphite | 6 g | | | |
| | Nitrilotriacetic acid | 0.5 g | | | |
| | Ion exchanged water | 842 g | | | |
| | Benzyl alcohol | 90 g | | | |
| | Sodium isopropylnaph-thalenesulfonate | 30 g | | | |
| | Triethanolamine | 30 g | | | |
| 5 | Monoethanolamine | 2 g | 270 ppm | 1:1 | good |
| | Sodium phosphite | 6 g | | | |
| | Sodium pyrophosphate | 1 g | | | |
| | Ion exchanged water | 841 g | | | |
| 6 | Same as Example 5 except that sodium pyrophosphate was replaced by an equal amount of potassium pyrophosphate | | 270 ppm | 1:1 | good |

Example 7

A solution comprising 20 g of a hexafluorophosphate salt of a p-diazodiphenylamine/para-formaldehyde condensate, 80 g of a p-hydroxyphenyl methacrylamide/acrylonitrile/methyl metha-crylate/methacrylic acid (monomer ratio in wt%: 20/35/35/10), 3 g of 85% phosphoric acid, e.g. of "Victoria Pure Blue-BOH" (dye from Hodogaya Chemical Co., Ltd.), 600 g of ethylene glycol monomethyl ether, 600 g of methanol and 600 g of ethylene dichloride was coated onto the aluminum plate of Example 1. The dry weight of the coating was 1.7 g/m². After imagewise exposure, the presensitized lithographic printing plate precursor was processed in a brush-equipped horizontally travelling automatic developing machine for 50

# 0 080 042

seconds with a developer (25°C) prepared by diluting the concentrated developer of Example 1 with well water (AH: 110 ppm) in a developer-to-water volume ratio of 1:2. The resulting lithographic printing plate had no unhardened photosensitive layer left on the nonimage area due to incomplete development.

A control concentrated developer that was the same as described above except that it contained no trisodium nitrilotriacetate as a water-softening agent was diluted with well water (AH: 110 ppm) in a volume ratio of 1:2. When the presensitized plate precursor was processed with this control developer (25°C) in the same automatic developing machine for 50 seconds, a printing plate having a film of unhardened photosensitive layer partially left on the nonimage area was produced, and this caused a heavy stain on printed matter.

## Claims

1. A developer for removing the unexposed area of a light-hardenable photosensitive layer including an organic high-molecular weight polymer with an acid value of 10 to 200 and a sulfonate or hexafluorophosphate of condensation products of p-diazodiphenyl amines and formaldehyde or acetaldehyde, said developer comprising an anionic surfactant, an organic solvent selected from benzyl alcohol and 2-phenoxyethanol, an alkali agent selected from at least one of the triethanolamine, diethanolamine and monoethanolamine, and water, characterized in that it further comprises from 0.01 to 5 wt% of a water softening agent having a sequestering ratio for calcium ions and/or magnesium ions of at least 50% at the pH of said developer.

2. The developer of claim 1, wherein said water softening agent is an aminopolycarboxylic acid or an aminopolycarboxylic acid alkali metal salt.

3. The developer of claim 1, wherein the amount of said water softening agent is 0.01 to 0.5 wt%.

4. The developer of claim 1, wherein said surfactant is a salt of a sulfate ester of a higher alcohol having 8 to 22 carbon atoms, a salt of an aliphatic alcohol phosphate ester, a salt of an alkylaryl sulfonic acid, a salt of an alkylamide sulfonic acid or a sulfate salt of a dibasic aliphatic acid ester.

5. A method of development comprising imagewise exposing a photosensitive material comprising a support having thereon a light-hardenable photo-sensitive layer including an organic high-molecular weight polymer with an acid value of 10 to 200 and a sulfonate or hexafluorophosphate of condensation products of p-diazodiphenyl amines and formaldehyde or acetaldehyde, and

processing said photosensitive material with a developer containing an anionic surfactant, an organic solvent selected from benzyl alcohol and 2-phenoxyethanol, an alkali agent selected from at least one of triethanolamine, diethanolamine and monoethanolamine, and water to remove the unexposed area of said photosensitive layer, characterized in that said developer further comprises from 0.01 to 5 wt% of a water-softening agent having a sequestering ratio for calcium ions and/or magnesium ions of at least 50% at the pH of said developer.

6. The method of claim 5, wherein said water softening agent is an aminopolycarboxylic acid or an aminopolycarboxylic acid alkali metal salt.

7. The method of claim 5, wherein the amount of said water softening agent is 0.01 to 0.5 wt%.

8. The method of claim 5, wherein said surfactant is a salt of a sulfate ester of a higher alcohol having 8 to 22 carbon atoms, a salt of an aliphatic alcohol phosphate ester, a salt of an alkylaryl sulfonic acid, a salt of an alkylamide sulfonic acid or a sulfate salt of a dibasic aliphatic acid ester.

9. The use of a developer according to any of claims 1 to 4, for removing the unexposed area of a light-hardenable photosensitive layer having an organic high-molecular weight polymer with an acid value of 10 to 200 and a sulfonate or hexafluorophosphate of condensation products of p-diazodiphenyl amines and formaldehyde or acetaldehyde.

## Patentansprüche

1. Enwickler zum Entfernen des unbelichteten Bereichs einer lichthärtbaren lichtempfindlichen Schicht, einschl. eines organischen Polymers mit hohem Molekulargewicht mit einem Säurewert von 10 bis 200 und eines Sulfonats oder Hexafluorphosphats von Kondensationsprodukten von p-Diazodiphenylaminen und Formaldehyd oder Acetaldehyd, wobei der Entwickler ein anionisches oberflächenaktives Mittel, ein organisches Lösungsmittel, gewählt aus Benzylalkohol und 2-Phenoxyethanol, ein alkalisches Mittel, gewählt aus wenigstens einem Triethanolamin, Diethanolamin und Monoethanolamin, und Wasser umfaßt, dadurch gekennzeichnet, daß er weiterhin 0,01 bis 5 Gew.-& eines Wasserenthärtungsmittels mit einem Maskierungs- bzw. Sequestierverhältnis für Calciumionen und/oder Magnesiumionen von wenigstens 50 % bei dem pH des Entwicklers umfaßt.

2. Einwickler nach Anspruch 1, worin das Wasserenthärtungsmittel eine Aminopolycarbonsäure oder ein Alkalimetallsalzeiner Aminopolycarbonsäure ist.

3. Entwickler nach Anspruch 1, worin die Menge des Wasserenthärtungsmittels 0,01 bis 0,5 Gew.-% beträgt.

4. Entwickler nach Anspruch 1, worin das oberflächenaktive Mittel ein Salz eines Sulfatesters eines höheren Alkohols mit 8 bis 22 Kohlenstoffatomen, ein Salz eines aliphatischen Alkoholphosphatester ein Salz einer Alkylarylsulfonsäure, ein Salz einer Alkylamidsulfonsäure oder ein Sulfatsalz eines zweibasischen aliphatischen Säureesters ist.

7

**0 080 042**

5. Entwicklungsverfahren, umfassend die bildweise Belichtung eines lichtempfindlichen Materials, das einen Träger mit einer darauf befindlichen lichthärtbaren lichtempfindlichen Schicht, einschl. eines organischen Polymers mit hohem Molekulargewicht mit einem Säurewert von 10 bis 200 und eines Sulfonates oder Hexafluorophosphats von Kondensationsprodukten von p-Diazodiphenylaminen und Formaldehyd oder Acetaldehyd, umfaßt und

die Behandlung des lichtempfindlichen Materials mit einen Entwickler, enthaltend ein anionisches oberflächenaktives Mittel, ein organisches Lösungsmittel, gewählt aus Benzylalkohol und 2-Phenoxyethanol, ein alkalisches Mittel, gewählt aus wenigstens einer Verbindung aus Triethanolamin, Diethanolamin und Monoethanolamin, und Wasser, zur Enternung des unbelichteten Bereichs der lichtempfindlichen Schicht, dadurch gekennzeichnet, daß der Entwickler weiterhin 0,01 bis 5 Gew.-% eines Wasserenthärtungsmittels mit einem Maskierungs- bzw. Sequenstierverhältnis für Calciumionen und/oder Magnesiumionen von wenigstens 50% bei dem pH des Entwicklers umfaßt.

6. Verfahren nach Anspruch 5, worin das Wasserenthärtungsmittel eine Aminopolycarbonsäure oder ein Alkalimetallsalz einer Aminopolycarbonsäure ist.

7. Verfahren nach Anspruch 5, worin die Menge des Wasserenthärtungsmittels 0,01 bis 0,05 Gew.-% beträgt.

8. Verfahren nach Anspruch 5, worin das oberflächenaktive Mittel ein Salz eines Sulfatesters eines höheren Alkohols mit 8 bis 22 Kohlenstoffatomen, ein Salz eines aliphatischen Alkoholphosphatesters ein Salz einer Alkylarylsulfonsäure, ein Salz einer Alkylamidsulfonsäure oder ein Sulfatsalz eines zweibasischen aliphatschen Säureesters ist.

9. Verwendung eines Entwicklers nach einem der Ansprüche 1 bis 4 zur Entfernung des unbelichteten Bereichs einer lichthärtbaren lichtempfindlichen Schicht mit einem organischen Polymer mit hohem Molekulargewicht mit einem Säurewert von 10 bis 200 und einem Sulfonat oder Hexafluorphosphat von Kondensationsprodukten von p-Diazodiphenylaminen und Formaldehyd oder Acetaldehyd.

**Revendications**

1. Révélateur pour éliminer les zones inexposées d'une couche photosensible photodurcissable comprenant un polymère organique à haut poids moléculaire ayant une valeur d'acidité de 10 à 200 et un sulfonate ou un hexafluorophosphate de produits de condensation de p-diazodiphényl amines et de formaldéhyde ou d'acétaldéhyde, ledit révélateur contenant un surfactif anionique, un solvant organique choisi parmi l'alcool benzylique et le 2-phénoxyéthanol, un agent alcalin choisi parmi au moins la triéthanolamine, la diéthanolamine et la monoéthanolamine, et l'eau, caractérisé en ce qu'il comprend en outre de 0,01 à 5% en poids d'un adoucisseur d'eau ayant un effect piégeant pour les ions calcium et/ou les ions magnésium d'au moins 50% au pH dudit révélateur.

2. Révélateur selon la revendication 1, caractérisé en ce que ledit adoucisseur d'eau est un acide aminopolycarboxylique ou un sel de métal alcalin d'acide aminopolycarboxylique.

3. Révélateur selon la revendication 1, caractérisé en ce que la quantité dudit adoucisseur d'eau est de 0,01 à 0,5% en poids.

4. Révélateur selon la revendication 1, caractérisé en ce que ledit surfactif est un sel d'un ester sulfate d'alcool supérieur ayant 8 à 22 atomes de carbone, un sel d'un ester phosphate d'alcool aliphatique, un sel d'un acide alkylaryl sulfonique, un sel d'un alkylamide d'acide sulfonique ou un sel sulfate d'ester d'acide aliphatique dibasique.

5. Procédé de développement comprenant l'exposition suivant l'image d'un matériau photosensible comprenant un support portant une couche photosensible photodurcissable contenant un polymère organique à haut poids moléculaire ayant une valeur d'acidité de 10 à 200 et un sulfonate ou un hexafluorophosphate de produits de condensation de p-diazodiphényl amines et de formaldéhyde ou d'acétaldéhyde, et le traitement dudit matériau photosensible par un révélateur contenant un surfactif anionique, un solvant organique choisi parmi l'alcool benzylique et le 2-phénoxyéthanol, un agent alcalin choisi parmi au moins la triéthanolamine, la diéthanolamine et la monoéthanolamine, et l'eau pour éliminer les zones inexposées de ladite couche photosensible, caractérisé en ce que ledit révélateur contient en outre de 0,01 à 5% en poids d'un adoucisseur d'eau ayant un effet piégeant pour les ions calcium et/ou les ions magnésium d'au moins 50% au pH dudit révélateur.

6. Procédé selon la revendication 5, caractérisé en ce que ledit adoucisseur d'eau est un acide aminopolycarboxylique ou un sel de métal alcalin d'acide aminopolycarboxylique.

7. Procédé selon la revendication 5, caractérisé en ce que la quantité dudit adoucisseur d'eau est de 0,01 à 0,5% en poids.

8. Procédé selon la revendication 5, caractérisé en ce que ledit surfactif est un sel d'un ester sulfate d'alcool supérieur ayant 8 à 22 atomes de carbone, un sel d'un ester phosphate d'alcool aliphatique, un sel d'un acide alkylaryl sulfonique, un sel d'un alkylamide d'acide sulfonique ou un sel sulfate d'ester d'acide aliphatique dibasique.

9. Utilisation d'un révélateur selon l'une quelconque des revendications 1 à 4, pour éliminer les zones inexposées d'une couche photosensible photodurcissable comprenant un polymère organique à haut poids moléculaire ayant une valeur d'acidité de 10 à 200 et un sulfonate ou un hexafluorophosphate de produits de condensation de p-diazodiphényl amines et de formaldéhyde ou d'acétaldéhyde.